# FASCICULE DE BREVET EUROPEEN

(11) **EP 0 958 545 B1**
(45) Date de publication et mention de la délivrance du brevet: **23.04.2003**
(21) Numéro de dépôt: 98906991.9
(22) Date de dépôt: 06.02.1998
(51) Int. Cl.: G06G 7/184

(54) **CIRCUIT INTEGRATEUR DE CHARGES PHOTOGENEREES A LINEARITE AMELIOREE**
INTEGRATORSCHALTUNG VON PHOTOERZEUGTEN LADUNGEN MIT VERBESSERTER LINEARITÄT
CIRCUIT FOR INTEGRATING LIGHT-INDUCED CHARGES WITH IMPROVED LINEARITY

(30) Priorité: 07.02.1997 FR 9701429
(43) Date de publication de la demande: 24.11.1999
(73) Titulaire: THALES ELECTRON DEVICES S.A., 78140 Vélizy (FR)
(72) Inventeur: DUCOURANT, Thierry, Thomson-CSF S.C.P.I., F-94117 Arcueil Cedex (FR)
(74) Mandataire: Beylot, Jacques
(86) Numéro de dépôt international: FR9800233
(87) Numéro de publication internationale: WO98035312

(56) Documents cités:
- SINGH S P ET AL: "A SIMPLE HIGH FREQUENCY CMOS TRANSCONDUCTOR" juin 1989 , PROCEEDINGS OF THE PACIFIC RIM CONFERENCE ON COMMUNICATIONS, COMPUTERS AND SIGNAL PROCESSING, VICTORIA,1 - 2 JUIN, 1989, NR. -, PAGE(S) 76 - 79 , INSTITUTE OF ELECTRICAL AND ELECTRONICS ENGINEERS XP000077442 164480 voir page 77, colonne de droite, ligne 34 - page 78, colonne de gauche, ligne 15; figures 5,6

## Description

L'invention concerne les circuits intégrateurs de charges photogénérées. Elle a pour but notamment, de limiter des défauts de linéarité engendrés par des capacités parasites.

De tels circuits ont pour fonction d'effectuer la transformation en tension, d'une quantité de courant ou charges accumulées durant un temps d'intégration. De tels circuits intégrateurs sont couramment utilisés dans différents domaines, parmi lesquels on peut citer celui des panneaux détecteurs d'images numérisées, notamment d'images numérisées radiologiques.

En prenant pour exemple les panneaux détecteurs d'images numérisée, ces derniers comportent généralement une matrice de points photosensibles. Chaque point photosensible délivre une quantité de charges proportionnelle à l'intensité d'un signal lumineux auquel il a été exposé. Pour chaque point photosensible, ces charges photogénérées sont converties en une valeur de tension qui ensuite est lue, puis mémorisée pour constituer un point élémentaire d'une image numérique.

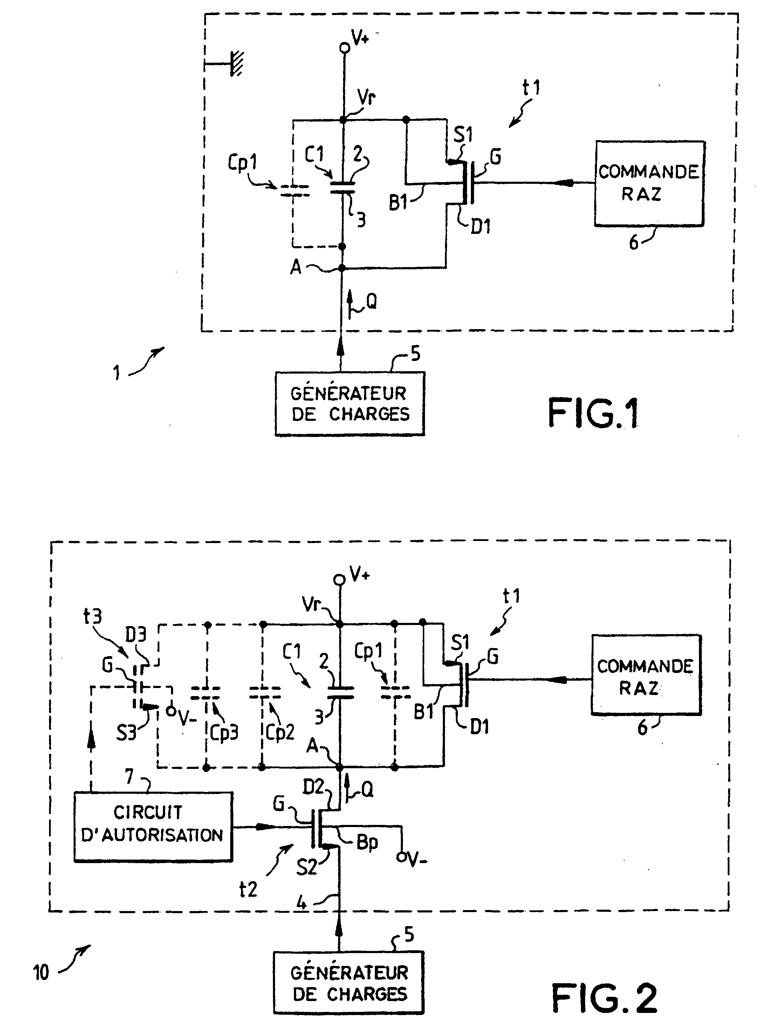

Le procédé le plus courant pour effectuer cette conversion en tension consiste à charger une capacité, comme montré à la figure 1.

La figure 1 représente un schéma classique d'un tel circuit intégrateur. Le circuit intégrateur 1 comporte une capacité dite d'intégration c1, dont une armature 2 est reliée à un potentiel de référence Vr : dans l'exemple représenté, ce potentiel de référence est constitué par un potentiel d'alimentation V+ positif par rapport à la masse générale du circuit ; mais la tension de référence peut être différente, comprise par exemple entre le potentiel d'alimentation V+ et la masse. La seconde armature 3 de la capacité d'intégration c1, est reliée à un point " A "où arrive un conducteur 4 transportant des charges Q. Ces charges destinées à être intégrées par la capacité d'intégration c1, sont délivrées par un générateur de charges 5, du type par exemple constitué par une matrice de points photosensibles.

Le point " A ", c'est à dire la seconde armature 3 de la capacité d'intégration c1, constitue un point à potentiel variable : la tension au point " A " varie par rapport au potentiel de référence V+, en fonction de la quantité de charge accumulée par la capacité d'intégration c1, suivant la relation : V=Q/c1, où V est l'augmentation de tension, Q est la quantité de charges et c1 est la capacité d'intégration.

La façon la plus simple de réaliser une capacité consiste par exemple, à la former à partir d'une grille de transistor du type MOS (de l'anglais " Métal Oxyde Semiconductor). Cependant les capacités de ce type sont non-linéaires, leur valeur varie avec la tension appliquée à leurs bornes. Aussi, pour garantir la linéarité des mesures, on préfère généralement constituer une capacité d'intégration telle que c1, par une capacité de type MIM (de l'anglais " Métal Isolant Métal ") qui elle est indépendante de la tension.

La capacité d'intégration c1 est amenée à intégrer successivement des quantités de charges Q appartenant à des mesures différentes et successives ; il est donc nécessaire avant chaque mesure, d'évacuer la charge stockée par la capacité d'intégration afin d'éviter des dérives de tension, et permettre de partir régulièrement d'une valeur de tension stable et connue aux bornes de la capacité d'intégration c1. Ceci est accompli par une opération dite de remise à zéro, qui consiste à court-circuiter la capacité d'intégration c1 à l'aide d'un élément remplissant une fonction d'interrupteur.

Pour effectuer cette opération de remise à zéro, il est classique d'utiliser un dispositif à semi-conducteur tel qu'un transistor de type MOS commandé en tout ou rien, comme représenté à la figure 1 par un transistor t1 de remise à zéro. Le transistor t1 est du type MOS, canal " P ", sa source S1 est reliée à la première armature 2 de la capacité d'intégration c1 et donc à la tension de référence V+. Le drain D1 du transistor t1 est relié au point " A "à potentiel variable, c'est à dire à la seconde armature 3 de la capacité d'intégration c1, et sa grille G est reliée à un circuit de commande de remise à zéro 6, dont elle reçoit un signal de commande de remise à zéro.

Un inconvénient du montage classique ci-dessus décrit, réside dans le fait que le drain D1 du transistor t1 de remise à zéro étant relié à la seconde armature 2, il ramène en parallèle sur la capacité d'intégration c1, une capacité parasite cp1 (représentée en pointillé sur la figure 1) qui est formée par une jonction que constitue ce drain D1. Il est bien connu en effet que le drain D1 mais aussi la source S1 d'un tel transistor t1, sont constitués chacun par une zone implantée dans un substrat semi-conducteur avec lequel ils forment chacun une jonction.

Le drain et la source sont constitués chacun par une zone semi-conductrice, dopée suivant un type de conductivité contraire de celui du substrat. Ainsi par exemple, un transistor de type P ou canal P possède un substrat dopé N qui est porté au potentiel positif de la tension d'alimentation appliquée au circuit (comme représenté à la figure 1 où le substrat B1 du transistor t1 est relié au potentiel positif V+) ; et le drain et la source de ce transistor sont formés par des zones dopées " N " implantées dans ce substrat. Un transistor de type N, est au contraire référencé par rapport à un substrat qui est au potentiel négatif de la tension d'alimentation.

Dans ces conditions, le drain D1 est constitué par une jonction polarisée dans le sens " bloqué ", c'est à dire par une diode polarisée en inverse, diode qui par suite constitue une capacité parasite cp1 disposée en parallèle avec la capacité d'intégration c1 (comme il est représenté en traits pointillés dans la figure).

La tension aux bornes de la capacité d'intégration c1 étant variable du fait de l'intégration des charges, et d'autre part ainsi que déjà indiqué plus haut, la valeur de la capacité parasite cp1 étant fortement dépendante de la tension à ces bornes, la capacité résultante possède une fraction importante de non-linéarité. Cette part de capacité non linéaire a bien entendu une influence d'autant plus marquée, que la capacité d'intégration c1 est de valeur faible.

Il est à remarquer que le problème ainsi posé par la présence de l'élément de commutation constitué par le transistor t1, est d'autant plus prononcé que l'on veut un intégrateur de grande sensibilité, sensibilité qui elle est d'autant plus grande que la capacité d'intégration est faible.

Dans le cas par exemple d'un circuit intégrateur recevant des charges produites par une matrice photosensible, il est courant que la capacité d'intégration ait une valeur de l'ordre de 0,3 à 0,5 pF. La non-linéarité engendrée par la seule capacité parasite, c'est-à-dire par la présence de l'interrupteur constitué par le transistor t1, peut atteindre 1%, et aller même jusqu'à 5%, pour une plage de tension de fonctionnement correspondant à une variation de tension de l'ordre de 3 volts.

Dans le but de diminuer l'influence de la capacité parasite cp1, une solution consiste à utiliser comme interrupteur des transistors MOS présentant une faible surface de jonction. Cependant les limites de cette solution sont rapidement atteintes sans donner vraiment satisfaction, car les éléments constitutifs de ces transistors ne peuvent être rendus assez petits pour des raisons d'ordre technologique.

En vue de réduire, voire de supprimer dans un circuit d'intégration, les effets néfastes d'une capacité parasite constituée par une jonction semi-conductrice rapportée notamment par un transistor comme ci-dessus expliqué, l'invention propose de compenser les différentes variations provenant de cette capacité parasite, par des variations accomplies dans un sens contraire et provenant d'au moins une autre jonction semi-conductrice.

Suivant l'invention, on propose un circuit intégrateur de charges photogénérées, comportant une capacité d'intégration dont une première armature est reliée à un potentiel de référence et une seconde armature à un point à potentiel variable où elle reçoit les charges photogénérées, un transistor MOS de remise à zéro, de premier type, relié d'une part au point à potentiel variable et d'autre part, à un potentiel d'alimentation, ce transistor de premier type présentant une capacité parasite en parallèle avec la capacité d'intégration. Ce circuit intégrateur est caractérisé en ce qu'il comporte un ou plusieurs transistors MOS de second type, reliés au point à potentiel variable, présentant chacun une capacité parasite en parallèle avec la capacité d'intégration, de manière qu'une variation de la tension aux bornes de la capacité d'intégration provoque une variation de la valeur de chacune des capacités parasites, la variation des capacités parasites des transistors MOS de second type tendant à compenser la variation de la capacité parasite du transistor MOS de premier type.

Dans ce circuit, le transistor MOS de premier type peut avoir son drain relié au point à potentiel variable et sa source reliée au potentiel d'alimentation. Ce transistor a une fonction d'interrupteur et sa grille est reliée à un circuit de commande de remise à zéro.

Ce circuit peut comporter comme transistor MOS de second type un transistor MOS relié par son drain au point à potentiel variable et qui reçoit les charges par sa source. Sa grille peut être reliée à un circuit d'autorisation de manière à former un interrupteur laissant passer les charges quand il est dans un état fermé.

Ce circuit peut comporter comme transistor MOS de second type un transistor MOS relié par sa source au point à potentiel variable et par son drain au potentiel d'alimentation. Ce transistor MOS de second type peut être commandé par sa grille et avoir une fonction d'interrupteur qui dans un état ouvert fige le potentiel du point à potentiel variable, ce qui permet d'obtenir une protection contre un éblouissement.

Si le circuit comporte les deux transistors MOS de second type décrits précédemment, il est possible que leurs grilles soient reliées au même circuit d'autorisation.

Le transistor de premier type est de type P tandis que les transistors de second type de type N.

Un circuit intégrateur comportant un premier dispositif à semi-conducteur, une capacité dite d'intégration reliée à un point à potentiel variable où elle reçoit des charges produites par un générateur de charges, le dispositif à semi-conducteur comportant une jonction d'un premier type dont une première zone ayant un premier type de conductivité est reliée au point à potentiel variable, et dont une seconde zone ayant un second type de conductivité (opposé au premier) est reliée à un premier potentiel d'alimentation par lequel la jonction est polarisée dans le sens inverse, comporte en outre au moins un second dispositif à semi-conducteur ayant une jonction d'un second type dont une première zone ayant le second type de conductivité est reliée au point à potentiel variable, et dont une seconde zone ayant le premier type de conductivité, est reliée à un second potentiel d'alimentation par lequel la jonction du second type est polarisée en inverse.

On notera que le document « A SIMPLE HIGH FREQUENCY CMOS TRANSCONDUCTOR » juin 1989, PROCEEDINGS OF THE PACIFIC RIM CONFERENCE ON COMMUNICATIONS, COMPUTERS AND SIGNAL PROCESSING, VICTORIA, 1 - 2 juin, 1989, NR.-, PAGE(S) 76-79, INSTITUTE OF ELECTRICAL AND ELECTRONICS ENGINEERS XP000077442 164480 by SINGH S P et AL décrit un transconducteur à deux transistors pouvant être utilisé dans un intégrateur destiné à intégrer une tension.

L'invention sera mieux comprise à la lecture de la description qui suit de certains de ces modes de réalisation, description faite à titre d'exemple non limitatif en référence aux dessins annexés, dans lesquels:
- la figure 1 déjà décrite représente un circuit d'intégration selon l'art antérieur ;
- la figura 2 représente le schéma d'un circuit intégrateur conforme à l'invention ;
- la figure 3 représente une structura semi-conductrice illustrent la mise en oeuvre de l'invention.

La figure 2 montre schématiquement un circuit intégrateur 10 suivant l'invention.

Le circuit intégrateur 10 comporte une capacité d'intégration c1 d'un même type que celle décrite en référence à la figure 1. La première armature 2 de la capacité d'intégration c1 est reliée à un potentiel de référence Vr, qui dans l'exemple non limitatif décrit, est constitué par un potentiel positif V+ d'une tension d'alimentation. La seconde armature 3 reçoit par un conducteur 4, des charges photogénérées représentées comme produites par un générateur de charges 5. Cette connexion constitue un point " A "dit " à potentiel variable ", où la tension varie en fonction des charges intégrées par la capacité d'intégration c1.

Comme dans l'exemple décrit en référence à la figure 1, un élément interrupteur est monté en parallèle avec la capacité d'intégration c1, en vue de réaliser des opérations de remise à zéro. Cette fonction d'interrupteur est réalisée par un transistor t1 d'un même type MOS que le transistor t1 de la figure 1, soit du type P dans l'exemple. Le drain D1 du transistor t1 est connecté au point " A " à potentiel variable ; sa source S1 est reliée au potentiel d'alimentation V+ ce qui dans l'exemple décrit correspondant aussi à la première armature 2 de la capacité d'intégration c1 ; et sa grille G est reliée à un circuit de commande de remise à zéro 6.

Ainsi qu'il a été indiqué plus haut dans le préambule, le transistor t1 constitue un dispositif à semi-conducteur comportant au moins une jonction jB1( non représentée à la figure 2), jonction dont la polarisation est telle qu'elle constitue une capacité parasite cp1 (montrée en traits pointillés sur la figure 2) rapportée en parallèle sur la capacité d'intégration c1.

En vue de compenser les effets produits par cette première jonction d'un premier type ci-dessus mentionnée, et suivant une caractéristique de l'invention, le circuit intégrateur 10 comporte en outre au moins un autre dispositif à semi-conducteur ayant au moins une jonction jB2 (non représentée à la figure 2) d'un second type présentant les caractéristiques suivantes :
- a) cette jonction jB2 du second type possède une première zone ayant un type de conductivité donné, et qui est reliée au point " A " à potentiel variable ;
- b) cette jonction jB2 du second type diffère de la jonction jB1 du premier type appartenant au premier dispositif à semi-conducteur t1, en ce que sa première zone est du type de conductivité contraire à celui de la première zone de la jonction jB1 du premier type ; ainsi par exemple, si la première zone de la jonction jB1 du premier type est dopée P, la première zone de la jonction jB2 du second type est dopée N ;
- c) enfin, cette jonction jB2 du second type possède une seconde zone ayant le type de conductivité opposé à celui de la première zone, laquelle seconde zone est reliée à un second potentiel d'alimentation dont la polarité par rapport au point " A " à potentiel variable est telle, que cette jonction jB2 du second type est polarisée en inverse.

Il en résulte que cette jonction jB2 d'un second type constitue elle aussi une capacité dite parasite cp2, connectée en parallèle avec la capacité d'intégration c1.

Cependant la seconde capacité parasite cp2, bien que de même nature que la première capacité parasite cp1, en diffère en ce qu'elle résulte de la polarisation en inverse d'une jonction différente, d'un type de conduction contraire de celui de la jonction ayant donné naissance à la première capacité parasite cp1. En conséquence, une variation de la tension aux bornes de la capacité d'intégration c1 provoque une variation de la valeur de chacune des capacités parasites cp1, cp2, dans des sens opposés l'une par rapport à l'autre. Ces variations de valeurs de capacités parasites ont ainsi tendance se compenser.

Dans l'exemple non limitatif décrit, l'autre ou second dispositif à semi-conducteur est constitué par un second transistor t2 du type MOS opposé à celui du transistor MOS t1, dans l'exemple à canal " N ", afin de comporter une jonction du second type ci-dessus décrite.

Le second transistor t2 est relié par son drain D2 au point " A "à potentiel variable, et son substrat Bp est relié au second potentiel d'alimentation V- ci-dessus cité, dont la polarité est négative par rapport au point " A '' à potentiel variable. Ceci suffit à réaliser la connexion de la jonction correspondant à ce drain D2, ainsi que sa polarisation en inverse, et par suite suffit à réaliser la seconde capacité parasite cp2. Il est à clair que ceci peut être obtenu également par un dispositif à semi-conducteur d'un autre type, par une diode par exemple. Il est à noter en outre que dans le cas d'un transistor MOS, la mise en place d'une seconde capacité parasite cp2 serait obtenue tout aussi bien en connectant, au point " A " à potentiel variable, la source de ce transistor plutôt que son drain. C'est ainsi que la figure 2 montre en pointillés un transistor MOS t3 de second type opposé à celui du transistor MOS t1 qui présente une capacité parasite cp3 en parallèle avec la capacité d'intégration c1. Ce transistor MOS t3 qui ici est de type N a sa source S3 reliée au point "A" à potentiel variable et son drain D3 relié au premier potentiel d'alimentation V+ ce qui correspond dans l'exemple à la première armature 2 de la capacité d'intégration c1 puisqu'on a Vr = V+. Son substrat Bp est aussi relié au second potentiel d'alimentation V- ci-dessus cité.

Le second transistor t2 ayant déjà son drain D2 connecté au point "A" à potentiel variable, il peut en outre assurer une autre fonction, additionnelle, comme par exemple d'autoriser, ou d'interdire le passage des charges et leur intégration, comme dans l'exemple non limitatif représenté à la figure 2 ; à la figure 2 en effet, le second transistor t2 est disposé entre le point "A " à potentiel variable, et le générateur de charges 5 auquel il est relié par sa source S2. Il est commandé par tout ou rien par un circuit d'autorisation 7 auquel sa grille G est reliée, de façon à constituer un interrupteur laissant passer les charges quand il est mis à l'état " fermé ".

Bien entendu, le second transistor pourrait tout aussi bien remplir une autre fonction additionnelle, l'important est qu'il soit connecté au point " A à potentiel variable par son drain D2 ou sa source S2, afin de connecter en ce point la seconde capacité parasite cp2.

Le transistor MOS t3 de second type peut être commandé par sa grille G et avoir une fonction d'interrupteur qui dans un état ouvert fige le potentiel du point "A" et permet de réaliser une protection contre un éblouissement, ce qui correspond à la situation où le potentiel au point "A" devient très négatif par rapport au potentiel V+.

Il est à remarquer également que la compensation peut être obtenue par plusieurs capacités parasites cp2, cp3 en parallèles formées à l'aide de plusieurs jonctions du second type, toutes reliées au point " A ", appartenant à des transistors et/ou à des diodes. Ainsi par exemple, le circuit intégrateur 10 pourrait comporter à la fois le transistor MOS t2 de second type et le transistor MOS t3 de second type que l'on vient de décrire qui est disposé en parallèle avec le premier transistor t1 c'est à dire qui a sa source S3 connectée au point " A " et son drain D3 connecté à là première armature 2 de la capacité d'intégration c1, de manière d'une part que sa jonction (du même type que la jonction du second transistor t2) forme une capacité parasite cp3 mise en parallèle avec celle cp2 du second transistor t2 ; et d'autre part que ce troisième transistor t3 assure une autre fonction, par exemple celle d'un interrupteur avec fonction d'antiéblouissement. Lorsque le circuit d'intégration 10 comporte les deux transistors MOS t2, t3 de second type leurs grilles G peuvent être reliées au même circuit d'autorisation 7.

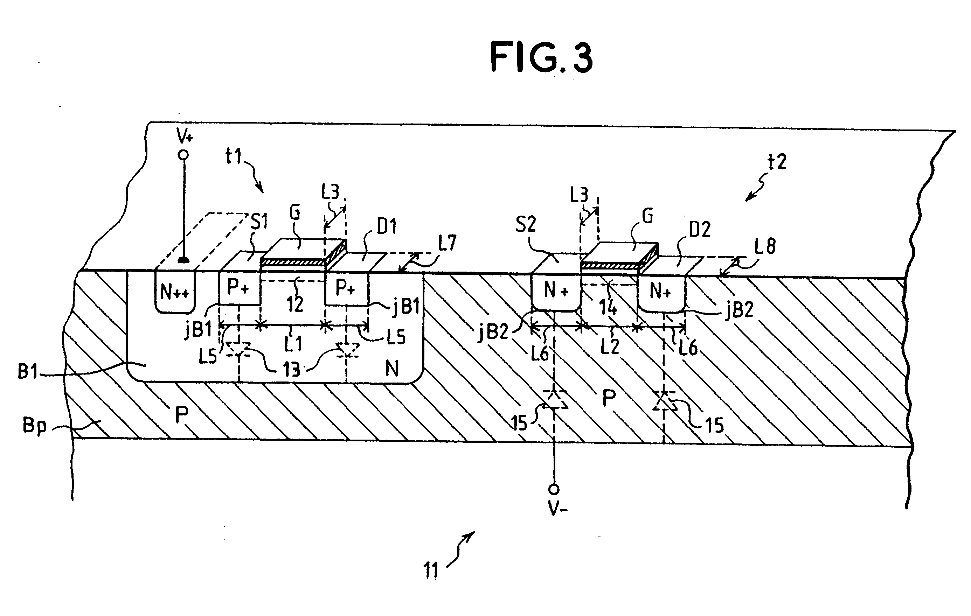

La figure 3 représente de manière simplifiée une structure semi-conductrice 11, portant les deux transistors t1, t2, et illustrant les mécanismes qui conduisent à former le capacités parasites cp1, cp2. La structure 11 est montrée par une vue en coupe, parallèle au canal de chacun de ces transistors. Elle comporte un substrat dit substrat principal Bp dopé suivant un premier type de conductivité P, dans lequel est implantée une large zone B1 formant le substrat du premier transistor t1. Ce substrat B1 est dopé suivant la second type de conductivité (opposé au premier), c'est à dire N.

Le drain D1 et la source S1 du premier transistor t1 sont formés chacun, d'une manière en elle-même classique, par une zone dopée P, implantée dans le substrat B1. Ils sont implantés à une distance l'un de l'autre qui représente la longueur L1 du canal 12 du transistor, canal au dessus duquel est disposée la grille G. Le drain D1 et la source S1 ayant un type de conductivité P opposé à celui (N) du substrat B1, ce drain et cette source forment chacun avec le substrat B1 une jonction semi-conductrice jB1 d'une diode 13 représentée en traits pointillés. La cathode de ces diodes 13 correspond au substrat B1, et leur anode correspond au drain et à la source c'est à dire à la zone dopée P. Le drain D1 et la source S1 constituent chacun la première zone précédemment citée d'une jonction jB1 du premier type, dont le substrat B1 est la seconde zone.

Conformément aux schéma des figures 1 et 2, le substrat B1 du premier transistor t1 est relié au premier potentiel d'alimentation V+, alors que le drain D1 est relié au point " A "à potentiel variable dont la tension est négative par rapport à ce premier potentiel V+. Il en résulte que les diodes 13 sont polarisées en inverse, et dans ces conditions elles constituent chacune une capacité, dont celle qui correspond au drain D1 constitue la première capacité parasite cp1 montrée aux figures 1 et 2.

Le drain D2 et la source S2 du second transistor t2, sont réalisés par des zones dopées avec le second type de conductivité c'est à dire N, implantées dans le substrat principal Bp (dopé P). Ils sont implantés à une distance l'un de l'autre qui représente la longueur L2 du canal 14 de ce transistor, canal au dessus duquel est disposée la grille G. Le drain D2 et la source S2 ayant un type de conductivité opposé à celui du substrat principal Bp, ce drain D2 et cette source S2 forment chacun avec ce substrat Bp une jonction semi-conductrice jB2 d'une diode 15 représentée en traits pointillés. L'anode de ces diodes 15 correspond au substrat principal Bp, et leur cathode correspond au drain D2 et à la source S2 c'est à dire à la zone dopée N. Le drain D2 et la source S2 constituent chacun la première zone précédemment citée d'une jonction jB2 du second type, dont le substrat principal Bp est la seconde zone.

Le substrat principal Bp du second transistor t2 est relié au second potentiel d'alimentation V-, alors que le drain D2 est relié au point " A "à potentiel variable dont la tension est positive par rapport à ce second potentiel d'alimentation V-. Il en résulte que comme dans le cas du premier transistor t1, les diodes 15 sont polarisées en inverse : dans ces conditions elles constituent chacune une capacité, dont celle qui correspond au drain D2 constitue la seconde capacité parasite cp2 montrée dans la figure 2.

Si la première capacité parasite cp1 est formée par plusieurs dispositifs à semi-conducteur, chacun d'eux comporte une jonction telle que la jonction du premier type jB1. Il en est de même en ce qui concerne la seconde capacité parasite cp2 : si elle est formée par plusieurs dispositifs à semi-conducteur, chacun d'eux comporte une jonction telle que la jonction du second type jB2.

La description a été faite en considérant que la capacité parasite à compenser était induite par une jonction du premier type jB1, dont la compensation s'effectue à l'aide d'une jonction jB2 du second type, mais bien entendu l'invention s'applique aussi bien dans le cas contraire.

La valeur des première et seconde capacités parasites cp1, cp2 produites respectivement par une ou des jonctions du premier type jB1 et une ou des jonctions du second type jB2, dépend à la fois de la tension de polarisation de jonction et de la surface de jonction : d'une part, la valeur de la capacité augmente quand la tension de polarisation inverse diminue, et d'autre part la valeur de la capacité augmente quand la surface de jonction augmente.

L'intégration des charges par la capacité d'intégration c1 peut engendrer au point « A » à potentiel variable une variation de tension représentant une plage de tension de fonctionnement VC comprise dans une différence de potentiel formée entre le premier V+ et le second V-potentiels d'alimentation.

Aussi, en vue d'optimiser la compensation l'une par l'autre des première et seconde capacités parasites cp1, cp2, dans la plage de tension de fonctionnement ou plage de codage VC prévue , dans laquelle opère l'intégrateur, l'invention propose d'adapter les dimensions des jonctions jB1, jB2, en fonction de la position de la plage de codage à l'intérieur de la différence de potentiel formée entre les première et seconde tensions d'alimentations V+, V-.

Entre une première et une seconde surfaces Sj1, Sj2 de jonction, dont la première Sj1 correspond à l'ensemble des surfaces de jonction du premier type jB1 connectées au point " A "à potentiel variable (et formant la première capacité parasite cp1), et dont la seconde Sj2 correspond à l'ensemble des surfaces de jonction du second type jB2 également connectées audit point " A "(et formant la seconde capacité parasite cp2), l'invention propose donc de conférer une plus grande dimension à celle des surfaces Sj1, Sj2 qui correspond au type de jonction jB1, jB2 se trouvant référencé à celui des potentiels d'alimentation V+, V- dont la plage de codage VC est la plus éloignée.

Par exemple, pour une plage de codage prévue de 3 volts :
- a) en supposant d'une part, que les premier et second potentiels d'alimentation V+, V- soient respectivement à +5 volts et à -5 volts par rapport à la masse, et que d'autre part la tension de référence Vr à laquelle est reliée la première armature 2 de la capacité d'intégration c1, soit une tension de +1,5 volt par rapport à la masse : dans ces conditions la tension centrale Vc de la plage de codage est au potentiel de la masse, c'est à dire centrée par rapport aux potentiels d'alimentation V+, V-, et les surfaces de jonction Sj1, Sj2 peuvent être sensiblement égales.
- b) pour des potentiels d'alimentations V+, V- respectivement à +5 volts et -5 volts comme ci-dessus, mais avec un potentiel de référence Vr différent (auquel est reliée la première armature 2 de la capacité d'intégration c1) constitué par exemple par le premier potentiel d'alimentation V+ (+5 volts) : dans ce cas pour une plage de codage de 3 volts, la valeur centrale de cette plage est à +3,5 volts, donc plus proche du potentiel positif V+ ou premier potentiel d'alimentation que du deuxième potentiel d'alimentation V- (négatif) ; dans ces conditions la seconde surface de jonction Sj2 (correspondant au second type de jonction jB2), est plus grande que la première surface de jonction Sj1.
- c) enfin, si la valeur centrale de la plage de codage est plus proche du potentiel d'alimentation négatif c'est à dire du second potentiel d'alimentation V-, la première surface de jonction Sj1 est plus grande que la seconde surface Sj2.

Dans certains domaines comme par exemple celui des détecteurs d'images, où des charges à mesurer et donc à intégrer sont produites par des matrices photosensibles, il est courant de fournir à l'intégrateur avant l'application des charges à mesurer, une quantité de charges formant par exemple des charges dites " d'entraînement ", ayant un niveau calibré. L'intégration de ces charges d'entraînement provoque une variation de la tension aux bornes de la capacité d'intégration, variation qui a pour effet de décaler la plage de codage.

Dans la configuration décrite ci-dessus, l'invention a permis d'obtenir des résultats très intéressants, car des valeurs de non-linéarités résiduelles ont été estimées à 0,05%, alors qu'elles sont généralement de l'ordre de 0,5% sans la compensation conforme à l'invention. Ces résultats ont été obtenus dans le cadre d'une technologie du type CMOS 2µm. (longueur de canal). La compensation d'une capacité parasite par une autre était optimisée pour une plage de tension de codage de 3 volts, centrée sur +2 volts, et avec des premier et second potentiels d'alimentation V+, V- respectivement de +5 volts et -5 volts, et la tension de référence Vr constituée par le premier potentiel d'alimentation V+. La première capacité parasite cp1 était constituée par le drain d'un transistor MOS canal P, monté d'une même manière que le premier transistor t1 ; et la seconde capacité parasite cp2 provenait du drain d'un transistor MOS canal N, monté d'une même façon que le second transistor t2. La surface de jonction conférée au drain du transistor canal N était de 70 µm², et la surface de jonction du drain du transistor canal P était de 25 µm². Bien entendu, ces dimensions sont données uniquement à titre indicatif et doivent être optimisées pour chaque type de procédé technologique.

Il peut être difficile de réduire la taille de certaines jonctions semiconductrices, notamment pour des questions de " prise de contact ", par contre leur taille peut aisément être augmentée sans inconvénients.

Dans la structure semi-conductrice 11 représentée à la figure 3 à titre d'exemple non limitatif, les surfaces des jonctions jB1, jB2 peuvent être facilement augmentées, sans modifier ni la longueur L1, L2 des canaux 12, 14, ni la largeur de ces canaux qui elle est particulièrement définie par la largeur L3 des grilles G. Il suffit à cet effet par exemple, d'accroître parallèlement à la longueur des canaux 12, 14, la longueur L5, L6 de l'une des implantations qui constituent les drains D1, D2 et les sources S1, S2 ; bien entendu l'accroissement de ces longueurs L5, L6 doit dans ce cas s'effectuer plutôt du côté opposé à celui qui borde le canal 12, 14. Il est possible aussi, en combinaison ou non avec l'augmentation de longueur L5, L6 citée ci-dessus, d'augmenter ces surfaces de jonction en augmentant la largeur L7, L8 des implantations (parallèlement à la largeur L3 du canal 12, 14) qui forment ces drains et ces sources.

La description ci-dessus a été faite en considérant que la capacité parasite à compenser était induite par une ou plusieurs jonctions du premier type jB1, dont la compensation s'effectue à l'aide d'une ou plusieurs jonctions jB2 du second type, mais bien entendu l'invention peut s'appliquer tout aussi bien dans le cas inverse.

Un circuit intégrateur 10 conforme à l'invention, est utilisable avantageusement dans tous les étages d'entrée de la plupart des amplificateurs de charges. De tels amplificateurs de charges sont couramment associés à des censeurs de lumière du genre constitué par des matrices de photodétecteurs.

## Revendications

1. Circuit intégrateur de charges photogénérées comportant une capacité d'intégration (c1) dont une première armature (2) est reliée à un potentiel de référence (Vr) et une seconde armature (3) à un point « A » à potentiel variable où elle reçoit les charges photogénérées, un transistor MOS (t1) de remise à zéro, de premier type (P) relié d'une part au point « A » à potentiel variable et d'autre part à un potentiel d'alimentation (V+), ce transistor MOS (t1) de premier type présentant une capacité parasite (cp1) en parallèle avec la capacité d'intégration (c1), **caractérisé en ce qu'**il comporte un ou plusieurs transistors MOS (t2, t3) de second type (N) opposé au premier type (P), reliés au point (« A ») à potentiel variable, présentant chacun une capacité parasite (cp2, cp3) en parallèle avec la capacité d'intégration (c1), de manière qu'une variation de la tension aux bornes de la capacité d'intégration (c1) provoque une variation de la valeur de chacune des capacités parasites (cp1, cp2, cp3), la variation des capacités parasites (cp2, cp3) des transistors MOS (t2, t3) de second type (N) tendant à compenser la variation de la capacité parasite (cp1) du transistor MOS (t1) de premier type.

2. Circuit intégrateur selon la revendication 1, **caractérisé en ce que** le transistor MOS (t1) de premier type (P) a son drain (D1) relié au point « A » à potentiel variable et sa source (S1) reliée au potentiel d'alimentation (V+).

3. Circuit d'intégration selon l'une des revendications 1 ou 2, **caractérisé en ce que** le transistor MOS (t1) de premier type (P) a une fonction d'interrupteur, sa grille (G) étant relié à un circuit de commande de remise à zéro (6).

4. Circuit d'intégration selon l'une des revendications 1 à 3, **caractérisé en ce qu'**il comporte comme transistor MOS (t2) de second type (N) un transistor MOS relié par son drain (D2) au point (« A ») à potentiel variable et qui reçoit les charges photogénérées par sa source (S2).

5. Circuit d'intégration selon la revendication 4, **caractérisé en ce que** le transistor MOS (t2) de second type (N) a une fonction d'interrupteur laissant passer les charges lorsqu'il est fermé, sa grille (G) étant reliée à un circuit d'autorisation (7).

6. Circuit d'intégration selon l'une des revendications 1 à 5, **caractérisé en ce qu'**il comporte comme transistor MOS (t3) de second type (N) un transistor MOS relié par sa source (S3) au point (« A ») à potentiel variable et par son drain (D3) au potentiel d'alimentation (V+).

7. Circuit d'intégration selon la revendication 6, **caractérisé en ce que** le transistor MOS (t3) de second type (N) est commandé par sa grille (G) et a une fonction d'interrupteur qui fige le potentiel du point (« A ») lorsqu'il est ouvert afin d'assurer une protection contre un éblouissement.

8. Circuit d'intégration selon les revendications 4 et 6, **caractérisé en ce que** les transistors MOS (t1, t3) de second type N ont chacun leur grille (G) reliée au même circuit d'autorisation (7).

9. Circuit d'intégration selon l'une des revendications 1 à 8, **caractérisé en ce que** le transistor MOS (t1) de premier type (P) est un transistor de type P et **en ce que** les transistors MOS (t2, t3) de second type (N) sont de type N.

## Patentansprüche

1. Schaltung für die Integration photoerzeugter Ladungen, mit einem Integrationskondensator (c1), wovon ein erster Belag (2) mit einem Referenzpotential (Vr) verbunden ist und ein zweiter Belag (3) mit einem Punkt "A" mit veränderlichem Potential verbunden ist, wo die photoerzeugten Ladungen empfangen werden, einem Nullrücksetz-MOS-Transistor (t1) eines ersten Typs (P), der einerseits mit dem Punkt "A" mit veränderlichem Potential und andererseits mit einem Versorgungspotential (V+) verbunden ist, wobei dieser MOS-Transistor (t1) des ersten Typs eine parasitäre Kapazität (cp1) aufweist, die zu der Integrationskapazität (c1) parallel ist, **dadurch gekennzeichnet, daß** sie einen oder mehrere MOS-Transistoren (t2, t3) eines zum ersten Typ (P) entgegengesetzten zweiten Typs (N) umfaßt, die mit dem Punkt ("A") mit veränderlichem Potential verbunden sind und jeweils eine parasitäre Kapazität (cp2, cp3) aufweisen, die zu der Integrationskapazität (c1) parallel ist, derart, daß eine Veränderung der Spannung an den Anschlüssen des Integrationskondensators (c1) eine Änderung des Wertes jeder der parasitären Kapazitäten (cp1, cp2, cp3) hervorruft, wobei die Änderung der parasitären Kapazitäten (cp2, cp3) der MOS-Transistoren (t2, t3) des zweiten Typs (N) bestrebt ist, die Änderung der parasitären Kapazität (cp1) des MOS-Transistors (t1) des ersten Typs auszugleichen.

2. Integrationsschaltung nach Anspruch 1, **dadurch gekennzeichnet, daß** der MOS-Transistor (t1) des ersten Typs (P) mit seinem Drain (D1) mit dem Punkt "A" mit veränderlichem Potential verbunden ist und mit seiner Source (S1) mit dem Versorgungspotential (V+) verbunden ist.

3. Integrationsschaltung nach einem der Ansprüche 1 oder 2, **dadurch gekennzeichnet, daß** der MOS-Transistor (t1) des ersten Typs (P) eine Ein/Aus-Schalterfunktion besitzt, wobei sein Gate (G) mit einer Nullrücksetz-Steuerschaltung (6) verbunden ist.

4. Integrationsschaltung nach einem der Ansprüche 1 bis 3, **dadurch gekennzeichnet, daß** sie als MOS-Transistor (t2) des zweiten Typs (N) einen MOS-Transistor umfaßt, der mit seinem Drain (D2) mit dem Punkt ("A") mit veränderlichem Potential verbunden ist und mit seiner Source (S2) die photoerzeugten Ladungen empfängt.

5. Integrationsschaltung nach Anspruch 4, **dadurch gekennzeichnet, daß** der MOS-Transistor (t2) des zweiten Typs (N) eine Ein/Aus-Schalterfunktion besitzt und die Ladungen durchläßt, wenn er geschlossen ist, wobei sein Gate (G) mit einer Zulassungsschaltung (7) verbunden ist.

6. Integrationsschaltung nach einem der Ansprüche 1 bis 5, **dadurch gekennzeichnet, daß** sie als MOS-Transistor (t3) des zweiten Typs (N) einen MOS-Transistor enthält, der mit seiner Source (S3) mit dem Punkt ("A") mit veränderlichem Potential verbunden ist und mit seinem Drain (D3) mit dem Versorgungspotential (V+) verbunden ist.

7. Integrationsschaltung nach Anspruch 6, **dadurch gekennzeichnet, daß** der MOS-Transistor (t3) des zweiten Typs (N) durch sein Gate (G) gesteuert wird und eine Ein/Aus-Schalterfunktion besitzt, die das Potential an dem Punkt ("A") fixiert, wenn er geöffnet ist, um einen Blendschutz sicherzustellen.

8. Integrationsschaltung nach den Ansprüchen 4 und 6, **dadurch gekennzeichnet, daß** die MOS-Transistoren (t1, t3) des zweiten Typs N mit ihrem Gate (G) jeweils mit derselben Zulassungsschaltung (7) verbunden sind.

9. Integrationsschaltung nach einem der Ansprüche 1 bis 8, **dadurch gekennzeichnet, daß** der MOS-Transistor (t1) des ersten Typs (P) ein P-Transistor ist und daß die MOS-Transistoren (t2, t3) des zweiten Typs (N) N-Transistoren sind.

## Claims

1. Integrator circuit for photogenerated charges,having an integration capacitor (c1) of which a first, plate (2) is connected to a reference potentiall (Vr)and a second plate (3)to a point "A" at variable potential where it receives the photogenerated charges,a resetting MOS transistor (t1) of a first type (P), connected on the one hand to the point "A" at variable potential and on the other hand to a supply potential (V+), this MOS transistor (t1) of the first type having a stray capacitance(cp1)in parallel with the integration capacitor(c1),**characterized in that** it has one or more MOS transistors (t2, t3) of a second type (N), which is the opposite of the first type (P), which are connected to the point ("A") at variable potential and each have a stray capacitance (cp2, cp3) in parallel with the integration capacitor (c1), so that a variation in the voltage across the terminals of the integration capacitor (c1) causes a variation in the value of each of the stray capacitances (cp1, cp2, cp3), the variation in the stray capacitances (cp2, cp3) of the MOS transistors (t2, t3) of the second type (N) tending to compensate for the variation in the stray capacitance (cp1) of the MOS transistor (t1) of the first type.

2. Integrator circuit according to Claim 1, **characterized in that** the MOS transistor (t1) of the first type (P) has its drain (D1) connected to the point "A" at variable potential and its source (S1) connected to the supply potential (V+).

3. Integration circuit, according to either ofClaims 1 and 2, **characterized in that** the MOS transistor (t1) of the first type (P). has a switch function, its gate (G) being connected to a resetting control circuit (6).

4. Integration circuit according to one of Claims 1 to 3, **characterized in that**, as the.MOS transistor (t2) of the second type (N) it has a MOS transistor which is connected via its drain (D2) to thde point ("A")at variable potential and which, receives the photogenerated charges via its source (S2).

5. Integration circuit according to Claim 4,**characterized in that** the MOS transistor (t2) of the second type (N) has a switch function allowing the charges to flow when it is closed, its gate (G) being connected to an enabling, circuit (7).

6. Integration circuit according to one of Claims 1 to 5, **characterized in that**, as the MOS. transistor (t3) of the second type (N), it has a MOS transistor connected via its source (S3) to the point ("A") at variable potential and via its drain, (D3) to the supply potential (V+).

7. Integration circuit according to Claim 6, **characterized in that** the MOS transistor (t3) of the second type (N) is controlled via its gate (G) and has a switch function which fixes the potential of the.point ("A") when it is open in order to provide protection against dazzling.

8. Integration circuit according to Claims 4 and 6, **characterized in that** the MOS transistors (t1, t3) of the second type N each have their gate (G) connected to the same enabling circuit (7).

9. Integration circuit according to one of Claims 1 to 8, **characterized in that** the MOS transistor (t1) of the first type (P) is a P-type transistor, and,**in that** the MOS transistors (t2, t3) of the second type (N) are N type.
